**Europäisches Patentamt**

**European Patent Office**

**Office européen des brevets** ·

(19)

(11) Veröffentlichungsnummer: **0 051 578**

**A2**

(12) # EUROPÄISCHE PATENTANMELDUNG

(21) Anmeldenummer: **81890183.7**

(22) Anmeldetag: **23.10.81**

(51) Int. Cl.³: **H 03 F 3/72**
**H 04 H 7/00**

(30) Priorität: **03.11.80 AT 5388/80**

(43) Veröffentlichungstag der Anmeldung:
**12.05.82 Patentblatt 82/19**

(84) Benannte Vertragsstaaten:
**DE FR GB NL**

(71) Anmelder: **SIEMENS AKTIENGESELLSCHAFT ÖSTERREICH**
**Apostelgasse 12**
**A-1030 Wien(AT)**

(72) Erfinder: **Kraker, Alfred**
**Kollergasse 17**
**A-1030 Wien(AT)**

(74) Vertreter: **Stich, Hermann Dipl.Ing.**
**Apostelgasse 12**
**A-1030 Wien(AT)**

(54) **Ausgangsstufe für Tonsignalleitungen.**

(57) Zur Ankopplung eines Tonkanales an eine für mehrere Tonkanäle vorgesehene Ausgangsleitung werden anstelle von Relaiskontakten in zunehmendem Maße elektronische Schalter verwendet, die jedoch den Nachteil aufweisen, daß sie in den Leitungsweg einen elektrischen Widerstand einbringen. Zur Umgehung der damit verbundenen Nachteile werden an den Koppelstellen eigene, als Impedanzwandler wirkende Ausgangsstufen eingesetzt, als welche vorzugsweise rückgekoppelte Operationsverstärker verwendet werden.

Der zur Stabilisierung des (freien) Ausgangspotentiales eines an den Tonkanal 4 nicht angeschlossenen Operationsverstärkers 2 dienender Kopplungswiderstand 3 mit hohem Widerstandswert ist jedoch nicht imstande, bei der Anschaltung des Ausganges an den Tonkanal 4 mittels eines elektronischen Schalters 5 den Einfluß von störenden Potential-differenzen zwischen dem Operationsverstärker-Ausgang und der Tonkanal-Ausgangsleitung 4 sowie von Offsetspannungen zu kompensieren.

Zu diesem Zweck ist gemäß der Erfindung ein zweiter Gegenkopplungswiderstand 7 mit geringem Widerstandswert vorgesehen, der mittels eines zweiten, zugleich mit dem Schalter 5 betätigten elektronischen Schalters 8 an den Tonkanal 4 angeschlossen wird. Der Gegenkopplungswiderstand 7 kompensiert die störenden Spannungsunterschiede zwischen Operationsverstärker-Ausgang und der Tonkanal-Ausgangsleitung 4.

FIG.1

## Ausgangsstufe für Tonsignalleitungen

Gegenstand der Erfindung ist eine Ausgangsstufe für Tonsignalleitungen, von deren Art, eine beliebige Anzahl, aber jeweils nur eine einzige gleichzeitig mittels elektronischer Schalter an eine gemeinsame Ausgangsleitung anschaltbar ist, wobei jede Ausgangsstufe je einen Operationsverstärker aufweist, dessen Ausgang über einen Gegenkopplungswiderstand mit seinem invertierenden Eingang verbunden ist.

In Tonstudioanlagen besteht vielfach die Notwendigkeit, die Signale verschiedener Tonkanäle jeweils einzeln einer gemeinsamen Ausgangsleitung (Bus-Leitung) zuzuführen, wobei es bekannt ist, zur Anschaltung Relaiskontakte zu verwenden. In manchen Anwendungsfällen, vor allem dann, wenn die Zu- und Abschaltungen der Tonkanäle von der Ausgangsleitung sehr rasch erfolgen sollen, sind elektronische Schalter den Relaiskontakten vorzuziehen, allerdings mit dem Nachteil, daß sie einen unvermeidlichen elektrischen Widerstand in den Leitungsweg einbringen. Es ist daher zweckmäßig, in den Tonkanälen ein Impedanzanpassungsglied und zwar einen gegengekoppelten Operationsverstärker vorzusehen. Dieser bedarf zum Ausgleich der Wirkungen von Offsetspannungen, die ohne erkennbare Ursache spontan im Eingangskreis auftreten, auf jeden Fall eines hochohmigen Gegenkopplungswiderstandes, der dauernd zwischen den Ausgang und dem invertierenden Eingang des Operationsverstärkers eingeschaltet ist. Es kann jedoch trotz Vorhandensein eines solchen hochohmigen Gegenkopplungswiderstandes der Fall eintreten, daß zwischen dem Ausgang des Operationsverstärkers und der Ausgangsleitung zum Zeitpunkt der Anschaltung eine Spannungsdifferenz herrscht, die bei der Anschaltung ein störendes Geräusch verursacht.

Die Erfindung hat sich die Aufgabe gestellt, dies bei Ausgangsstufen mit Operationsverstärkern mit Gegenkopplungswiderständen zu vermeiden und erzielt dies dadurch, daß diesem ersten Gegenkopplungswiderstand sowie einem den Ausgang des Operationsverstärkers an die Ausgangsleitung anschließenden ersten elektronischen Schalter mittels eines zweiten elektronischen Schalters ein zweiter Gegenkopplungswiderstand, dessen Widerstandswert wesentlich geringer ist als der des ersten Gegenkopplungswiderstandes, synchron parallelschaltbar ist.

Zufolge dieser erfindungsgemäßen Maßnahme wirkt sich eine allenfalls vor der Anschaltung bestehende Spannungsdifferenz auf die Gegenkopplung im Sinne einer Kompensation dieser Spannungsdifferenz aus. Nach weiteren Merkmalen können die elektronischen Schalter entweder einzeln oder gemeinsam mittels Kondensatoren an die Ausgangsleitung angeschlossen werden.

Ausführungsbeispiele der Erfindung sind in der Zeichnung dargestellt.

Fig. 1 zeigt eine Ausgangsstufe mit direkt an die Ausgangsleitung angeschlossenen elektronischen Schaltern. Bei den Ausführungen nach den

Fig. 2 und 3 sind die elektronischen Schalter einzeln bzw. gemeinsam über Kondensatoren an die Ausgangsleitung angeschlossen.

In allen Ausführungsbeispielen ist einheitlich mit 1 die Signalspannungsquelle des betreffenden Tonkanales bezeichnet, die an den nichtinvertierenden Eingang (+) eines zugeordneten Operationsverstärkers 2 angeschlossen ist. Dieser ist mit einem ersten Gegenkopplungswiderstand 3 versehen, der den Ausgang des Operationsverstärkers 2 mit dessen invertierendem Eingang (-) verbindet und der zur Kompensation von Offsetspannungen, die im Eingangskreis auftreten können, dient.

Die Ausgangsleitung, an die mehrere Tonkanäle mit gleichartig aufgebauten Ausgangsstufen angeschlossen sind, ist mit 4 bezeichnet. Zum
Anschluß des Ausganges des Operationsverstärkers 2 an die Ausgangsleitung 4 dient ein elektronischer Schalter 5, der der Übersichtlichkeit wegen in Form eines Kontaktes dargestellt ist. Der entlang der
Schaltstrecke des elektronischen Schalters 5 auftretende elektrische
Widerstand ist durch den Widerstand 6 symbolisiert.

Zur Kompensation von Spannungsdifferenzen zwischen dem Ausgang des
Operationsverstärkers 2 und der Ausgangsleitung 4 dient ein zweiter
Gegenkopplungswiderstand 7, der ebenso wie der erste Gegenkopplungswiderstand 3 einerseits an den invertierenden Eingang (-) des Operationsverstärkers 2 angeschlossen ist und anderseits mittels eines zweiten elektronischen Schalters 8, der ebenfalls als Kontakt dargestellt
ist, an die Ausgangsleitung 4 anschließbar ist. Der Widerstand der
Schaltstrecke des elektronischen Schalters 8 ist durch einen Widerstand
9 symbolisiert.

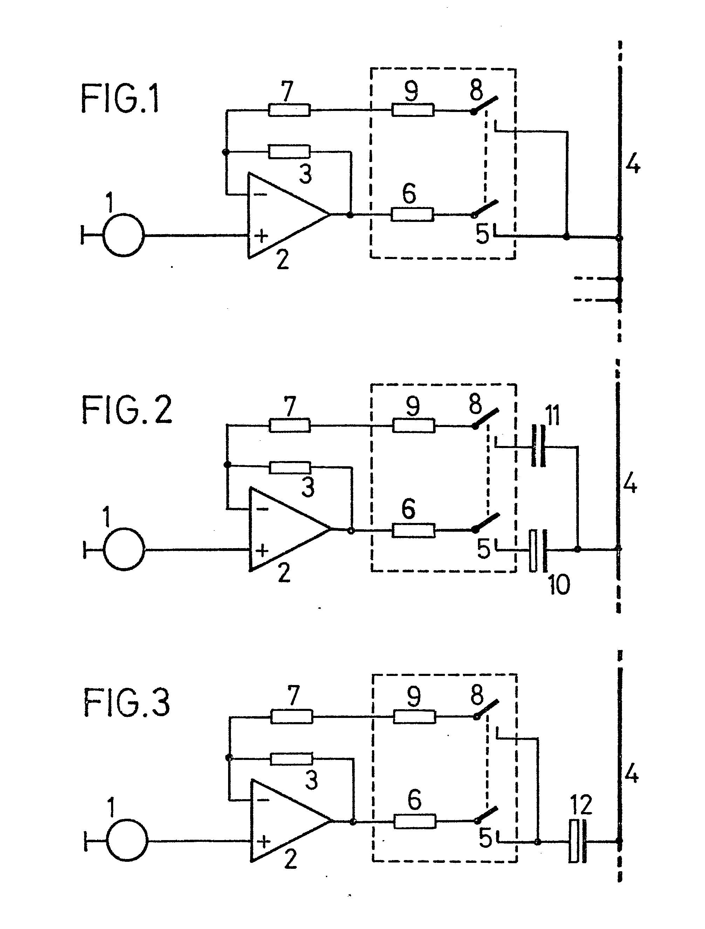

Die Tonkanäle können auch von der Ausgangsleitung 4 galvanisch getrennt
werden wie beispielsweise bei der Ausführung nach Fig. 2, bei der die
beiden elektronischen Schalter 5 und 8 mittels je eines zugeordneten
Kondensators 1o bzw. 11 an die Ausgangsleitung 4 angeschlossen sind.
Hierbei muß der das Tonsignal übertragende Kondensator 1o eine entsprechend große Kapazität aufweisen, wofür vorzugsweise ein Elektrolytkondensator vorzusehen ist. Es kann aber auch gegebenenfalls mit
einem einzigen Kondensator das Auslangen gefunden werden, wenn, wie in
Fig. 3 dargestellt, beide elektronische Schalter 5 und 8 gemeinsam über
einen Kondensator 12, der zweckmäßig auch ein Elektrolytkondensator ist,
an die Ausgangsleitung 4 angeschlossen werden.

Wie durch die die beiden elektronischen Schalter 5 und 8 verbindende
strichlierte Linie symbolisiert ist, werden diese auf nicht näher dargestellte Weise synchron aktiviert. Es ist zweckmäßig, solche elektronische Schalter zu verwenden, die in integrierter Schaltkreistechnik in einem einzigen Bauteil zusammengefaßt sind, was in der Zeichnung durch die strichlierten Umrandungen angedeutet ist.

Bezüglich der Bemessung der Widerstände ist festzulegen, daß die Summe der Widerstandswerte der Widerstände 7 und 9 um einige Größenordnungen geringer ist als der Widerstandwert des ersten Gegenkopplungswiderstandes 3. Ein spezielles Beispiel für die Bemessung der verwendeten Schaltungselemente ist: Summe der Widerstände 7 und 9 : 1oo $\Omega$ ; Gegenkopplungswiderstand 3 : 47o k $\Omega$ ; Kondensator 11 : 1 $\mu$F; Kondensatoren 1o bzw. 12 : 22o $\mu$F.

Patentansprüche:

1. Ausgangsstufe für Tonsignalleitungen, von deren Art eine beliebige Anzahl, aber jeweils nur eine einzige gleichzeitig mittels elektronischer Schalter an eine gemeinsame Ausgangsleitung anschaltbar ist, wobei jede Ausgangsstufe je einen Operationsverstärker aufweist, dessen Ausgang über einen Gegenkopplungswiderstand mit seinem invertierenden Eingang verbunden ist, dadurch gekennzeichnet, daß diesem ersten Gegenkopplungswiderstand (3) sowie einem den Ausgang des Operationsverstärkers (2) an die Ausgangsleitung (4) anschließenden ersten elektronischen Schalter (5) mittels eines zweiten elektronischen Schalters (8) ein zweiter Gegenkopplungswiderstand (7), dessen Widerstandswert wesentlich geringer ist als der des ersten Gegenkopplungswiderstandes (3), synchron parallelschaltbar ist.

2. Ausgangsstufe nach Anspruch 1, dadurch gekennzeichnet, daß jeder der beiden elektronischen Schalter (5, 8) über je einen Kondensator (1o, 11) an die Ausgangsleitung (4) angeschlossen ist, wobei der dem ersten elektronischen Schalter (5) zugeordnete Kondensator (1o) eine wesentlich größere Kapazität aufweist als der andere Kondensator (11) und insbesondere ein Elektrolytkondensator ist.

3. Ausgangsstufe nach Anspruch 1, dadurch gekennzeichnet, daß die beiden elektronischen Schalter (5, 8) gemeinsam über einen Kondensator (12), insbesondere Elektrolytkondensator an die Ausgangsleitung (4) angeschlossen sind.

FIG.1

FIG.2

FIG.3